# EUROPEAN PATENT APPLICATION

(11) **EP 4 300 029 A1**
(43) Date of publication of application: **03.01.2024**
(21) Application number: 23205054.2
(22) Date of filing: 20.10.2023
(51) Int. Cl.: G01B 5/00, C23C 14/54, G01B 17/02

(54) **MEASURING DEVICE FOR MEASURING A THICKNESS OF A FILM OF MATERIAL DEPOSITED ON A SUBSTRATE AND FILM DEPOSITION APPARATUS WITH AT LEAST ONE SUCH MEASURING DEVICE**

(71) Applicant: Evatec AG, 9477 Trübbach (CH)
(72) Inventor: HERDE, Adrian, 8634 Hombrechtikon (CH); SCHÜNGEL, Edmund, 9470 Buchs (CH)
(74) Representative: Troesch Scheidegger Werner AG

(57) **Abstract**

A measuring device (6) for measuring a thickness of a film of material deposited on a substrate is proposed. The measuring device (6) comprises a first compartment (7') having a first housing (7) and an electrical drive (9) arranged within said first housing (7) and a second compartment (8') having a second housing (8) and a crystal carrier (10) adapted to accommodate a plurality of crystals (11) releasably mounted within said second housing (8). The second housing (8) has a measuring aperture (12) and the second housing (8) and the crystal carrier (10) are moveable relative to one another such that any one of the plurality of crystals (11) can be brought into alignment with the measuring aperture (12) as a measuring crystal by motion imposed by operation of the electrical drive (9). The electrical drive (9) is drivingly connected with a first magnet arrangement (13) located in the first compartment (7') and a second magnet arrangement (14) in the second compartment (8') is connected with the second housing (8) or with a part thereof or with the crystal carrier (10), such that a magnetic coupling exists between the electrical drive (9) and the second housing (8) or the part thereof or the crystal carrier (10) allowing to impose said motion by the electrical drive (9). Furthermore, a film deposition apparatus with one or more such measuring devices (6) is provided.

## Description

### TECHNICAL FIELD

This disclosure generally relates to devices for measuring the thickness of a thin film of material deposited on a substrate and for monitoring the deposition rate of a film deposition apparatus such as a vacuum coating apparatus.

In particular, a measuring device using a quartz crystal sensor as part of a crystal oscillator is described, where the crystal is disposed inside a vacuum chamber together with a substrate in order to measure a resonance frequency of the crystal oscillator during film formation on a substrate and simultaneously on the crystal located in close proximity of the substrate in a vacuum atmosphere such that the thickness of the film formed on the crystal is representative of the thickness of the film formed on the substrate. More particularly, the proposed measuring device comprises a crystal carrier adapted to accommodate a plurality of crystals, such that the current/active measuring crystal can be replaced with a fresh spare crystal when necessary. Furthermore, a film deposition apparatus such as a vacuum coating apparatus, e.g., by evaporation, sputtering, chemical vapor deposition (CVD) or atomic layer deposition (ALD), with one or more such measuring devices is provided.

### BACKGROUND OF THE INVENTION

Quartz crystal sensors - often referred to as "quartz crystal microbalance" (QCM) - are widely used to accurately measure the amount of material, i.e., the thickness of the film of material, that is deposited as well as to determine the rate of deposition onto a surface, such as a substrate for manufacturing semiconductor, optical or display devices. In such a sensor a piezoelectric crystal, e.g., made of silicon dioxide (SiO₂), lagasite (lanthanum gallium silicate, LGS), lithium tantalate (LiTaO₃) or gallium orthophosphate (GaPO₄), is connected into a resonance circuit so that the resonance frequency of the crystal can be monitored. Thereby the crystal is disposed in the interior of the processing chamber in close relation to (i.e., proximity of) the substrate being coating with the material. Because the resonance frequency is primarily dependent upon the total mass and geometry of the crystal, the resonance frequency drops dependent on the amount of material that is deposited onto the crystal during the deposition process. However, as the deposited material builds up, the sharpness of the composite resonance diminishes, and eventually a point is reached at which the crystal cannot adequately monitor the process accurately or effectively anymore. At this point, the piezoelectric crystal must be replaced. Typically, this requires stopping processing of substrates, opening the film deposition apparatus, and having to manually exchange the old crystal with a new one. Thus, measurement crystal replacement is a cumbersome and costly process that leads to machine downtime. Furthermore, having to shut down and subsequently ramp up the production process again is time consuming and may require careful re-adjustment of certain process parameters.

Known deposition rate measurement devices incorporating exchangeable crystals as well as means and methods for exchanging crystals are for instance described in US4362125, US5025664, US9182378B2 and US10767987B2.

There remains much room for improvement and a need for alternative means and methods for exchanging crystals which are addressed in the following.

### SUMMARY OF THE INVENTION

It is an object of the present invention to provide an alternative as well as improved measuring device for measuring film thickness and monitoring deposition rate in a film deposition apparatus. Such a measuring device is specified in claim 1.

It is a further aim of the present invention to appropriately equip a film deposition apparatus with an alternative and improved measuring device. Such a film deposition apparatus is given in claim 12.

Specific embodiments of the proposed measurement device and film deposition apparatus are given in the dependent claims.

A proposed measuring device for measuring a thickness of a film of material deposited on a substrate comprises a first compartment having a first housing and an electrical drive (i.e., a motor) arranged within said first housing, and a second compartment having a second housing and a crystal carrier adapted to accommodate a plurality of crystals releasably mounted within said second housing. The second housing has at least one measuring aperture/opening, and the second housing and the crystal carrier are moveable relative to one another such that any one of the plurality of crystals can be brought into alignment with the measuring aperture as a measuring crystal by motion imposed by operation of the motor. The motor is drivingly connected with a first magnet arrangement located in the first compartment and a second magnet arrangement located in the second compartment is connected with the second housing or with a part thereof, such as a lid, or with the crystal carrier, such that a magnetic coupling exists between the motor and the second housing or the part thereof or the crystal carrier allowing to impose said motion by the motor.

In an embodiment of the measuring device the first housing is fixedly attached to the first compartment, the second housing is fixedly attached to the second compartment and the crystal carrier is moveably attached to the second compartment, in particular by means of a slide contact bearing, or alternatively the second housing is moveably attached to the second compartment, in particular by means of a slide contact bearing, and the crystal carrier is releasably affixed to the second compartment.

In a further embodiment of the measuring device the first magnet arrangement is mounted on a drive shaft of the motor and the second magnet arrangement is mounted on a shaft rotatably mounted in the second compartment.

In a further embodiment of the measuring device the second housing or the crystal carrier is fixedly attached to the shaft rotatably mounted in the second compartment.

In a further embodiment of the measuring device the first compartment is hermetically sealed from the second compartment. In particular, the first compartment is adapted to be operable at an atmospheric pressure while the second compartment is adapted to be operable at a vacuum pressure.

In a further embodiment of the measuring device an interior of the first compartment is essentially thermally isolated from the second compartment. In particular, the first compartment, more particularly the first housing, comprises a heat shield, in particular a thermal isolator, adapted and configured to prevent heat transfer from the second compartment to the first compartment. The first compartment for instance comprises a sheath made of a metallic material, e.g., stainless steel, titanium, or a coated aluminium material. This sheath acts as a thermal radiation shielding to protect in particular the electronics for controlling the electrical drive. The electronics are in particular directly mounted on a cooling surface, e.g., of a heatsink. The cooling surface may be actively cooled by means of a cooling fluid provided to the first compartment via a cooling conduit/line from an exterior (of the process chamber). A cooling fluid may also be provided to actively cool the second compartment.

In a further embodiment of the measuring device the first compartment comprises a cooling conduit adapted to provide a cooling fluid to the first compartment from an exterior. In this way the first compartment can be actively cooled. Furthermore, this can also provide active cooling to the second compartment, if the second compartment is not thermally well isolated from the first compartment (e.g., by means of a heat shield located between them). If cooling of the second compartment by means of the cooling conduit provided in the first compartment is desired, then a (tight) thermal coupling between the first and second compartment is desired and can be achieved by having an extensive direct contact of the first housing with the second housing.

In a further embodiment the measuring device further comprises a chopper unit arranged in front of the measuring aperture/opening opposite to the measuring crystal, wherein the chopper unit comprises a rotatable chopper plate or disc with at least one inlet such as a hole or slit for controlling/regulating an amount of material deposited onto the measuring crystal.

In a further embodiment of the measuring device the motor is in particular a stepping motor, and the measuring device further comprises a position sensor, such as a rotary encoder, adapted to determine a position, in particular a rotary angle, of the crystal carrier relative to the measuring aperture/opening.

In a further embodiment the measuring device further comprises a magnetic shield, in particular in form of a yoke plate, adapted and configured to shield the measuring crystal against magnetic fields from the first and second magnet arrangement.

In a further embodiment of the measuring device a torque of the magnetic coupling is greater than a holding torque of the motor. This ensures that the motor does not slip position relative to the crystal carrier (and/or position sensor).

Additionally, a proposed film deposition apparatus, such as a vacuum coating apparatus, in particular for performing evaporation, sputtering, chemical vapor deposition or atomic layer deposition, comprises a process chamber and disposed within said process chamber an evaporation or sputtering source and/or at least one gas inlet, a substrate holder for accommodating a substrate and a first measuring device as described above, the measuring device in particular being located in close proximity / the vicinity of the substrate holder, e.g., next thereto, such as to be exposed to a similar deposition of material as the substrate during operation film deposition apparatus. In order to extend the operational life of the measuring crystal a chopper may be employed with the help of which the amount on material deposited on the measuring crystal may be controlled by means of the masking provided by a chopper disc.

In an embodiment the film deposition apparatus comprises at least one further measuring device as described above disposed within the process chamber, in particular at a peripheral location relative to the substrate holder, to enable monitoring of a uniformity of the thickness of the film of material deposited on a substrate together with the first measuring device, as for instance commonly located in a centre of the film deposition apparatus.

It is expressly pointed out that combinations of the embodiments mentioned above can result in even further, more specific embodiments.

### BRIEF DESCRIPTION OF THE DRAWINGS

The present invention is further explained below by means of non-limiting specific embodiments and with reference to the accompanying drawings, which show the following:
- Fig. 1: a schematic cross-sectional side view of an exemplary embodiment of the proposed film deposition apparatus;
- Fig. 2: a schematic cross-sectional side view of an exemplary embodiment of the proposed measuring device;
- Fig. 3: a schematic cross-sectional side view of a further exemplary embodiment of the proposed measuring device;
- Fig. 4: a schematic cross-sectional side view of yet another exemplary embodiment of the proposed measuring device; and
- Fig. 5: a schematic exploded view of the exemplary embodiment of the measuring device according to Fig. 2 additionally with a chopper disc: a) first compartment & b) second compartment.

In the figures like reference signs refer to like parts.

### DETAILED DESCRIPTION OF THE INVENTION

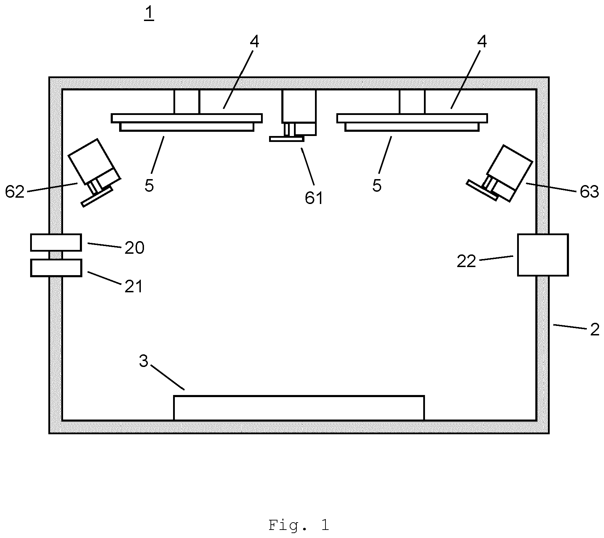

Fig. 1 shows a schematic cross-sectional side view of an exemplary embodiment of the proposed film deposition apparatus 1. The film deposition apparatus 1 may be an evaporation or sputtering apparatus. Alternatively, the film deposition apparatus 1 may for instance be adapted and configured to perform chemical vapor deposition (CVD) or atomic layer deposition (ALD) or plasma enhanced versions of these processes, i.e., PECVD and PEALD. The film deposition apparatus 1 comprises a process chamber 2, in particular a vacuum chamber. Disposed within the process chamber 2 is e.g., an evaporation source 3 or a sputtering source and/or one or more gas inlets 20, 21, e.g., for providing precursor gas and/or reactive gas for CVD or ALD, and at least one substrate holder 4 for accommodating a substrate 5 (or a plurality of substrates) - in the example illustrated in Fig. 1 two substrate holders 4 are shown. A first measuring device 61 is located in between the two substrate holders 4 in close proximity (i.e., next) to both, such as to be exposed to a similar deposition of material as the substrates 5 mounted on the substrate holders 4 during operation of the film deposition apparatus 1. Furthermore, a second and third measuring device 62, 63 may be disposed within the process chamber 2 at a peripheral location relative to the substrate holders 4, to enable monitoring of a uniformity of the thickness of the film of material deposited on the substrates 5 together with the first measuring device 61. The process chamber may further comprise a pumping port 22.

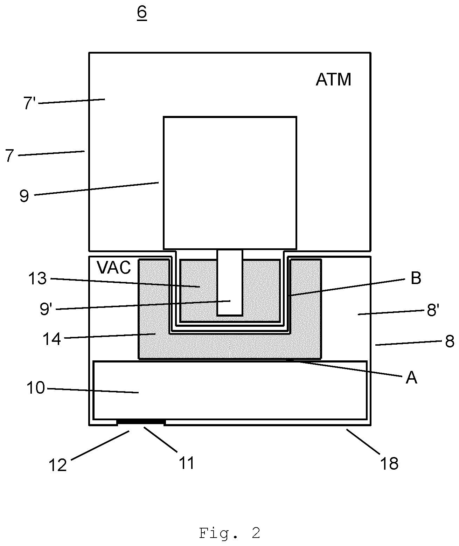

Fig. 2 shows a schematic cross-sectional side view of an exemplary embodiment of the proposed measuring device 6 for measuring a thickness of a film of material deposited on a substrate. The measuring device 6 comprises a first compartment 7' with a first housing 7 and a second compartment 8' with a second housing 8. A motor 9 (e.g., an electrical drive system) is arranged within the first housing 7 and a crystal carrier 10 adapted to accommodate a plurality of crystals 11 is releasably mounted within the second housing 8. The second housing 8 has at least one measuring aperture/opening 12. The second housing 8 and the crystal carrier 10 are moveable relative to one another such that any one of the plurality of crystals 11 mounted on the crystal carrier 10 can be brought into alignment with the measuring aperture 12 as a measuring crystal by motion imposed by operation of the motor 9. The motor 9 is drivingly connected with a first magnet arrangement 13 located in the first compartment 7' and a second magnet arrangement 14 located in the second compartment 8' is connected with the second housing 8 or with a part thereof, e.g., a lid 18, or with the crystal carrier 10, such that a magnetic coupling exists between the motor 9 and the second housing 8 or a part thereof or the crystal carrier 10 allowing to impose motion by the motor 9 to the second housing 8 or to a part thereof (e.g., the lid 18 comprising the measuring aperture/opening 12) or to the crystal carrier 10.

The first housing 7 is fixedly attached to the first compartment 7'. In an embodiment the second housing 8 is fixedly attached to the second compartment 8' and the crystal carrier 10 is moveably attached to the second compartment 8', in particular by means of a bearing such as for instance a slide contact bearing. In an alternative embodiment the second housing 8 is moveably attached to the second compartment 8', in particular by means of a bearing such as for instance a slide contact bearing, and the crystal carrier 10 is releasably affixed to the second compartment 8', whereby the crystal carrier 10 does not move but the measuring aperture/opening 12 can be moved relative to the stationary crystal carrier 10.

In an embodiment the first magnet arrangement 13 can be mounted on a drive shaft 9' of the motor 9 and the second magnet arrangement 14 can be mounted on a shaft rotatably mounted in the second compartment 8'.

In an embodiment the second housing 8 is fixedly attached to the shaft rotatably mounted in the second compartment 8', and in an alternative embodiment the crystal carrier 10 is fixedly attached to the shaft rotatably mounted in the second compartment 8'.

In the embodiment shown in Fig. 2 the first magnet arrangement 13 has a cylindrical form and is mounted on the drive shaft 9' of the motor 9 and the second magnet arrangement 14 has a U-shaped cross-section. The bottom of the cylinder of the first magnet arrangement 13 is preferably closed and is arranged opposite to the bottom of the second magnet arrangement 14. The lateral surface of the first magnet arrangement 13 is surrounded by the sidewall of the second magnet arrangement 14 such that the magnetic coupling essentially takes place in horizontal direction.

The second magnet arrangement 13 may be attached to the crystal carrier 10 (e.g., at location A in Fig. 2) so that the crystal carrier 10 can be rotated by motion of the motor 9, or alternatively the second magnet arrangement 13 may be attached to the second housing 8 (e.g., at location B in Fig. 2) so that whilst the crystal carrier 10 remains still/stationary the measuring aperture 12 (located at the bottom of the second housing 8) can be rotated by motion of the motor 9. As a further alternative, only a part of the second housing 8 at which the measuring aperture 12 is located, e.g., a separate cover such as a lid 18, may be attached to the second magnet arrangement 13, such that this part with the measuring aperture 12 can be rotated by motion of the motor 9, whilst the rest of the second housing 8 and the crystal carrier 10 remain still/ stationary.

The first compartment 7' can be hermetically sealed from the second compartment 8'. In particular, the first compartment 7' can be operated at an atmospheric pressure (indicated by ATM in Fig. 2) while the second compartment 8' can be operated at a vacuum pressure (indicated by VAC in Fig. 2).

In order to protect the motor 9 and the associated electronics the interior of the first compartment 7' can be essentially thermally isolated from the second compartment 8'. For instance, the first compartment 7', in particular the first housing 7, can comprise a heat shield, in particular a thermal isolator, configured to prevent heat transfer from the second compartment 8' to the first compartment 7.

The motor 9 can be a stepping motor. The measuring device 6 may include a position sensor, such as a rotary encoder, adapted to determine a position, in particular a rotary angle, of the crystal carrier 10 relative to the measuring aperture/opening 12.

The measuring device 6 may comprise a magnetic shield, in particular in form of a yoke plate, adapted and configured to shield the measuring crystal 11 against magnetic fields from the first and second magnet arrangement 13, 14.

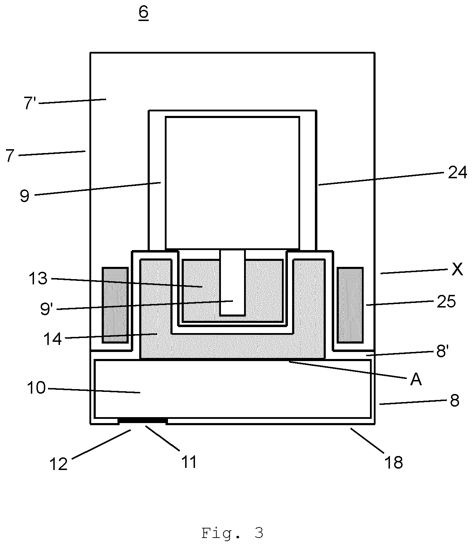

Fig. 3 shows a schematic cross-sectional side view of a further exemplary embodiment of the proposed measuring device 6. Compared with the embodiment depicted on Fig. 2 the first compartment 7' in Fig. 3 comprises an extension X laterally extends partly over the second compartment 8'. A cooling conduit 25 adapted to provide a cooling fluid, e.g., water, to the first compartment 7', in particular to the extension X of the first compartment 7', from an exterior, is arranged within the extension X. In this way the first compartment 7' can be actively cooled. Furthermore, this can also provide active cooling to the second compartment 8', if the second compartment 8' is in (close/good) thermal contact with the first compartment 7' (i.e., is not thermally well isolated from the first compartment 7', e.g., by means of a heat shield located between them). If cooling of the second compartment 8' by means of the cooling conduit 25 provided within the extension X of first compartment 7' is desired, then a (tight) thermal coupling between the first and second compartment 7', 8' is desired and can be achieved by having an extensive direct contact of the first housing 7 with the second housing 8.

As can be seen in Fig. 3, a heat shield 24 (i.e., a thermal isolator) is provided within the first compartment 7' / housing 7, in particular enclosing the electronics for controlling the motor 9 (as well as the motor 9 itself). The heat shield 24 is in the form of a sheath made of a metallic material, e.g., stainless steel, titanium, or a coated aluminium material. This sheath acts as a thermal radiation shielding to protect in particular the electronics for controlling the electrical drive.

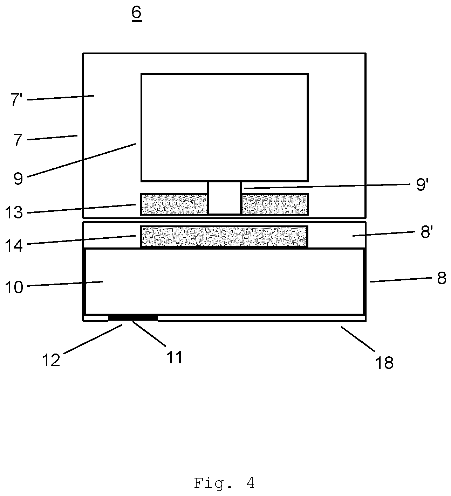

Fig. 4 shows a schematic cross-sectional side view of an alternative embodiment of the proposed measuring device 6. Here the first magnet arrangement 13 has the form of a disc which is mounted on the drive shaft 9' of the motor 9 and the second magnet arrangement 14 also has the form of a disc of (essentially) the same dimension/extent/radius.

The disc of the first magnet arrangement 13 is arranged opposite to the disc of the second magnet arrangement 14. In this configuration the magnetic coupling essentially takes place in vertical direction.

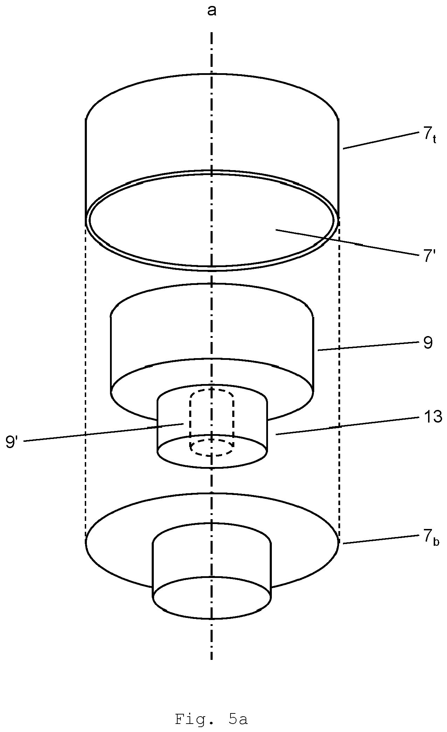

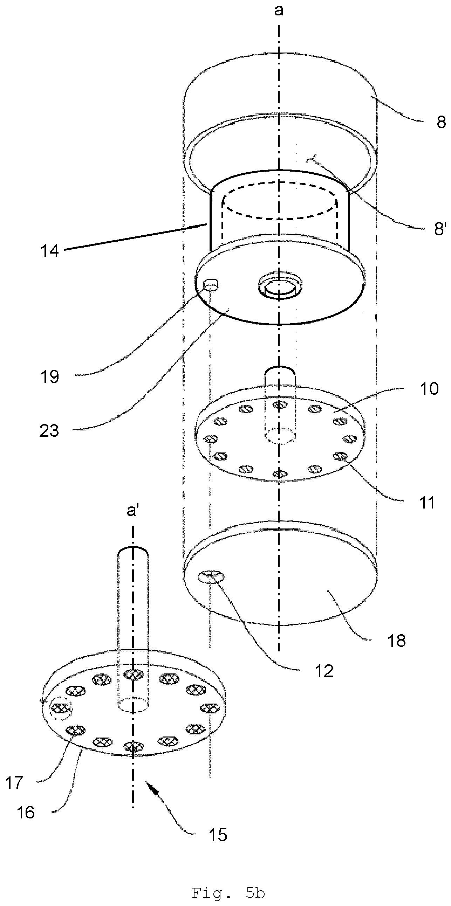

Fig. 5a & 5b together illustrate in a schematic exploded view the exemplary embodiment of the measuring device 6 according to Fig. 2 with a chopper disc 16, where Fig. 5a shows the first compartment 7' and Fig. 5b shows the second compartment 8'. The motor 9 with the drive shaft 9' extending downwards below the motor 9 can be seen in the middle of Fig. 5a. The first magnet arrangement 13 surrounds the drive shaft 9' and is attached thereto. The motor electronics are located on top of the motor 9. This arrangement is located within the first housing comprising the top part 7ₜ and the bottom part 7_{b}. All these parts are arranged together as the first compartment 7' along the measuring device's central axis a.

The plate- or disc-form crystal carrier 10 with multiple crystals 11 arrange along the periphery can be seen in the middle of Fig. 4b. The crystal carrier 10 is releasably affixed to a mounting disc 23. The mounting disc 23 comprises a contact for electrically connecting measurement crystal to measurement circuit. This contact establishes an electrically connection with the measurement crystal 11 when the measurement crystal 11 is in the correct the measuring position, i.e., when aligned with the measuring aperture/opening 12. The mounting disc 23 is attached to the second magnet arrangement 14 that has the shape of a hollow cylinder into which the first magnet arrangement can be inserted, when the first and second compartments 7', 8' are assembled together. The crystal carrier 10 connected to the mounting disc 23 attached to the second magnet arrangement 14 is located in the second compartment 8' enclosed by the second housing 8 which includes a bottom lid with the measuring aperture/opening 12. All these parts too are arranged together along the measuring device's central axis a. The rotatable chopper disc 16 of the chopper unit 15 has of plurality of holes 17 which are evenly distributed along the periphery of the disc 16 such that a hole 17 of the disc 16 periodically aligns with the measuring aperture/opening 12 as the disc 16 steadily rotates around the disc's axis a'. By periodically covering the measuring aperture/opening 12 the amount of material deposited onto the measuring crystal 11 is reduced and thus the operational life of the measuring crystal 11 can be extended.

A chopper unit 15 can be arranged in front of the measuring aperture/opening 12 opposite to the measuring crystal 11. The chopper unit 15 comprises a rotatable chopper plate or disc 16 with a plurality of evenly spaced apart holes 17 or slits in radial direction for controlling/regulating the amount of material deposited onto the measuring crystal 11.

### LIST OF REFERENCE SYMBOLS

- 1: film deposition apparatus
- 2: process chamber
- 3: evaporation or sputtering source
- 4: substrate holder
- 5: substrate
- 6: measuring device
- 61: first measuring device
- 62: second measuring device
- 63: third measuring device
- 7: first housing
- 7_{b}: bottom part of first housing
- 7ₜ: top part of first housing
- 7': first compartment
- 8: second housing
- 8': second compartment
- 9: electrical drive / motor
- 9': drive shaft of motor
- 10: crystal carrier
- 11: crystal
- 12: measuring aperture/opening
- 13: first magnet arrangement
- 14: second magnet arrangement
- 15: chopper unit
- 16: chopper disc
- 17: hole or slit
- 18: lid (of second housing)
- 19: contact for electrically connecting measurement crystal to measurement circuit
- 20: controllable precursor gas inlet
- 21: controllable reactive gas inlet
- 22: pumping port
- 23: mount for releasably attaching crystal carrier
- 24: sheath / heat shield
- 25: cooling conduit/line for providing cooling fluid to first compartment from an exterior

- a: measuring device central axis
- a': axis of chopper disc
- X: extension of first compartment

## Claims

1. A measuring device (6; 61, 62, 63) for measuring a thickness of a film of material deposited on a substrate (5), comprising:
- a first compartment (7') having a first housing (7) and an electrical drive (9) arranged within said first housing (7); and
- a second compartment (8') having a second housing (8) and a crystal carrier (10) adapted to accommodate a plurality of crystals (11) releasably mounted within said second housing (8),
wherein the second housing (8) has at least one measuring aperture (12), and
wherein the second housing (8) and the crystal carrier (10) are moveable relative to one another such that any one of the plurality of crystals (11) can be brought into alignment with the measuring aperture (12) as a measuring crystal by motion imposed by operation of the electrical drive (9),
wherein the electrical drive (9) is drivingly connected with a first magnet arrangement (13) located in the first compartment (7') and that a second magnet arrangement (14) located in the second compartment (8') is connected with the second housing (8) or with a part thereof or with the crystal carrier (10), such that a magnetic coupling exists between the electrical drive (9) and the second housing (8) or the part thereof or the crystal carrier (10) allowing to impose said motion by the electrical drive (9).

2. The measuring device (6; 61, 62, 63) of claim 1, wherein the first housing (7) is fixedly attached to the first compartment (7'), and wherein the second housing (8) is fixedly attached to the second compartment (8') and the crystal carrier (10) is moveably attached to the second compartment (8'), in particular by means of a slide contact bearing, or wherein the second housing (8) is moveably attached to the second compartment (8'), in particular by means of a slide contact bearing, and the crystal carrier (10) is releasably affixed to the second compartment (8').

3. The measuring device (6; 61, 62, 63) of claim 1 or 2, wherein the first magnet arrangement (13) is mounted on a drive shaft (9') of the electrical drive (9) and wherein the second magnet arrangement (14) is mounted on a shaft rotatably mounted in the second compartment (8').

4. The measuring device (6; 61, 62, 63) of claim 3, wherein the second housing (8) or the crystal carrier (10) is fixedly attached to the shaft rotatably mounted in the second compartment (8').

5. The measuring device (6; 61, 62, 63) of any one of claims 1 to 4, wherein the first compartment (7') is hermetically sealed from the second compartment (8'), in particular the first compartment (7') is operable at an atmospheric pressure while the second compartment (8') is operable at a vacuum pressure.

6. The measuring device (6; 61, 62, 63) of any one of claims 1 to 5, wherein an interior of the first compartment (7') is essentially thermally isolated from the second compartment (8'), in particular wherein the first compartment (7'), in particular the first housing (7), comprises a heat shield, in particular a thermal isolator, configured to prevent heat transfer from the second compartment (8') to the first compartment (7').

7. The measuring device (6; 61, 62, 63) of any one of claims 1 to 6, wherein the first compartment (7') comprises a cooling conduit (25) adapted to provide a cooling fluid to the first compartment (7') from an exterior.

8. The measuring device (6; 61, 62, 63) of any one of claims 1 to 7, further comprising a chopper unit (15) arranged in front of the measuring aperture (12) opposite to the measuring crystal (11), wherein the chopper unit (15) comprises a rotatable chopper plate or disc (16) with at least one inlet such as a hole or slit (17) for controlling an amount of material deposited onto the measuring crystal (11).

9. The measuring device (6; 61, 62, 63) of any one of claims 1 to 8, wherein the electrical drive (9) is in particular a stepping motor and wherein the measuring device (6; 61, 62, 63) further comprises a position sensor, such as a rotary encode, adapted to determine a position, in particular a rotary angle, of the crystal carrier (10) relative to the measuring aperture (12).

10. The measuring device (6; 61, 62, 63) of any one of claims 1 to 9, further comprising a magnetic shield, in particular in form of a yoke plate, adapted and configured to shield the measuring crystal (11) against magnetic fields from the first and second magnet arrangement (13, 14) .

11. The measuring device (6; 61, 62, 63) of any one of claims 1 to 10, wherein a torque of the magnetic coupling is greater than a holding torque of the electrical drive (9) .

12. A film deposition apparatus (1), such as a vacuum coating apparatus, in particular for performing evaporation, sputtering, chemical vapor deposition or atomic layer deposition, comprising a process chamber (2) and disposed within said process chamber (2) an evaporation or sputtering source (3) and/or at least one gas inlet (20, 21), a substrate holder (4) for accommodating a substrate (5) and a first measuring device (61) according to any one of the claims 1 to 11, the measuring device (61) in particular being located in close proximity of the substrate holder (4), e.g., next thereto, such as to be exposed to a similar deposition of material as the substrate (5) during operation film deposition apparatus (1) .

13. The film deposition apparatus (1) of claim 12, comprising at least one further measuring device (62, 63) according to any one of the claims 1 to 11 disposed within the process chamber (2), in particular at a peripheral location relative to the substrate holder (4), to enable monitoring of a uniformity of the thickness of the film of material deposited on the substrate (5) together with the first measuring device (61).
